(19) Europäisches Patentamt / European Patent Office / Office européen des brevets

(11) **EP 2 249 431 A1**

(12) **DEMANDE DE BREVET EUROPEEN**

(43) Date de publication:
**10.11.2010 Bulletin 2010/45**

(51) Int Cl.:
***H01P 1/20*** *(2006.01)*

(21) Numéro de dépôt: **10160432.0**

(22) Date de dépôt: **20.04.2010**

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**
Etats d'extension désignés:
**AL BA ME RS**

(30) Priorité: **30.04.2009 FR 0952870**

(71) Demandeur: **STMicroelectronics (Tours) SAS 37100 Tours (FR)**

(72) Inventeurs:
• **Guitton, Fabrice**
  **37380 Monnaie (FR)**
• **Thon, Benjamin**
  **37100 Tours (FR)**

(74) Mandataire: **de Beaumont, Michel**
  **Cabinet Beaumont**
  **1, rue Champollion**
  **38000 Grenoble (FR)**

(54) **Filtre de mode commun**

(57) L'invention concerne un filtre (2) de mode commun comportant deux bornes (22, 24) d'entrée et deux bornes (26, 28) de sortie, et en série entre chaque borne d'entrée ou de sortie et la masse, un élément capacitif (C25, C26) et un premier élément inductif (L29).

Fig 3

EP 2 249 431 A1

**Description**

Domaine de l'invention

La présente invention concerne de façon générale les circuits électroniques et, plus particulièrement, les filtres de mode commun utilisés dans de tels circuits.

Exposé de l'art antérieur

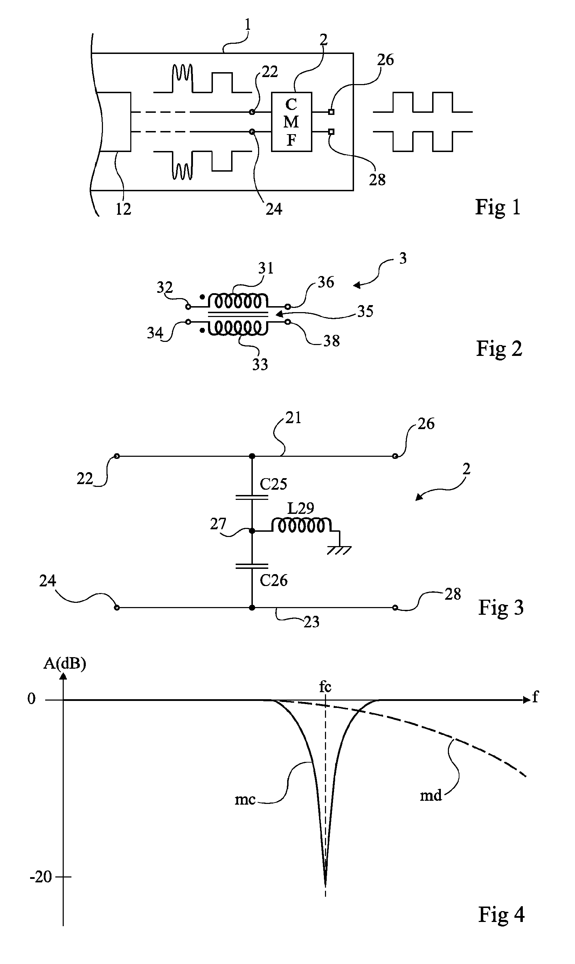

La figure 1 est un schéma bloc d'une carte électronique 1 comportant, outre un ou plusieurs circuits 12 susceptibles de fournir des signaux différentiels, au moins un filtre de mode commun 2 (CMF) du type auquel s'applique la présente invention. Un tel filtre comporte deux bornes d'entrée 22 et 24 et deux bornes de sortie 26 et 28. Les bornes d'entrée sont destinées à recevoir les signaux différentiels à traiter dont le résultat filtré est fourni en sortie.

Comme l'illustrent les exemples d'allures de signaux en figure 1, le rôle d'un filtre de mode commun est de laisser passer les signaux différentiels qui sont en opposition de phase et d'atténuer ou couper les signaux et perturbations de mode commun qui sont en phase sur les deux entrées. Un filtre de mode commun idéal est un court-circuit pour les signaux en opposition de phase en entrée et un circuit ouvert pour les signaux en phase. En pratique, le filtre laisse toujours passer les basses fréquences, donc un niveau de polarisation commun aux deux signaux différentiels.

Des filtres de mode commun sont généralement utilisés pour des accès de données différentiels dans des circuits de traitement numérique, notamment si la fréquence des signaux utiles est dans le même domaine que la fréquence des signaux que l'on cherche à rejeter.

On trouve également des filtres de mode commun dans des circuits analogiques, par exemple pour traiter des signaux dans des microphones différentiels dont le signal est transmis de façon symétrique.

La figure 2 représente un exemple de filtre de mode commun 3 usuel. Un tel filtre est constitué de deux inductances 31 et 33 reliant respectivement des accès 32 d'entrée et 36 de sortie et des accès 34 d'entrée et 38 de sortie. Les inductances sont couplées par un matériau magnétique 35. Les points de phase respectifs des inductances 31 et 33 sont du même côté (dans l'exemple, côté des bornes d'entrée 32 et 33) afin de ne pas filtrer les signaux en opposition de phase.

Le principe de fonctionnement du filtre 3 de la figure 2 est de présenter une impédance série élevée pour des signaux en phase et une impédance série faible pour des signaux en opposition de phase.

Le recours à un matériau magnétique 35 est lié au besoin d'avoir des inductances de forte valeur susceptibles de présenter une impédance série élevée en mode commun, sans que la taille du filtre ne devienne trop importante. Un matériau magnétique permet d'obtenir des inductances de valeurs élevées avec peu de tours, donc une faible résistance série.

Cette solution est donc limitée aux applications dans lesquelles on peut utiliser un tel matériau magnétique. Ce n'est en particulier pas le cas pour intégrer des filtres de mode commun notamment sur des substrats de verre.

Un inconvénient lié à l'utilisation d'un matériau magnétique est une saturation en présence d'un champ magnétique élevé.

Par ailleurs, l'utilisation d'un matériau magnétique est particulièrement onéreuse.

Il existe donc un besoin d'un filtre de mode commun dépourvu de matériau magnétique.

Résumé

La présente invention vise à pallier tout ou partie des inconvénients des filtres de mode commun usuels.

Un mode de réalisation de la présente invention vise plus particulièrement à éviter le recours à un matériau magnétique dans un filtre de mode commun.

Un autre objet d'un mode de réalisation de la présente invention est d'éviter d'accroître la résistance série par la présence du filtre de mode commun dans un circuit électronique.

Un autre objet d'un mode de réalisation de la présente invention est de proposer une solution aisément intégrable notamment sur des substrats de verre.

Pour atteindre tout ou partie de ces objets ainsi que d'autres, il est prévu un filtre de mode commun comportant deux bornes d'entrée et deux bornes de sortie, et en série entre chaque borne d'entrée ou de sortie et la masse, un élément capacitif et un premier élément inductif.

Selon un mode de réalisation de la présente invention, le premier élément inductif est commun à tous les éléments capacitifs.

Selon un mode de réalisation de la présente invention, une première borne d'entrée est directement reliée ou est commune à une première borne de sortie, et une seconde borne d'entrée est directement reliée ou est commune à une seconde borne de sortie.

Selon un mode de réalisation de la présente invention, une première borne d'entrée est reliée à une première borne de sortie par un deuxième élément inductif, et une seconde borne d'entrée est reliée à une seconde borne de sortie par un troisième élément inductif.

Selon un mode de réalisation de la présente invention, les deuxième et troisième éléments inductifs sont couplés.

Selon un mode de réalisation de la présente invention :

les bornes d'entrée sont connectées par deux éléments capacitifs en série ;

les bornes de sortie sont connectées par deux autres éléments capacitifs en série, les points milieu des associations en série respectives des éléments capacitifs étant interconnectés à une première borne du premier élément inductif dont l'autre borne est à la masse.

Selon un mode de réalisation de la présente invention, les éléments capacitifs sont formés par des diodes dont les anodes respectives sont côté premier élément inductif, une diode additionnelle étant connectée en parallèle sur cet élément inductif.

Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :

    la figure 1 décrite précédemment représente un exemple de circuit électronique du type auquel s'applique à titre d'exemple la présente invention ;
    la figure 2 décrite précédemment représente un exemple usuel de filtre de mode commun ;
    la figure 3 représente un mode de réalisation d'un filtre de mode commun ;
    la figure 4 illustre la réponse en fréquence du filtre de la figure 3 ;
    la figure 5 représente un autre mode de réalisation d'un filtre de mode commun ;
    la figure 6 illustre la réponse en fréquence du filtre de la figure 5 ;
    la figure 7 représente encore un autre mode de réalisation d'un filtre de mode commun, protégé contre d'éventuelles décharges électrostatiques.

Description détaillée

De mêmes éléments ont été désignés par de mêmes références aux différentes figures. Par souci de clarté, seuls les éléments utiles à la compréhension de l'invention ont été représentés et seront décrits. En particulier, les circuits connectés en amont ou en aval d'un filtre de mode commun n'ont pas été détaillés, l'invention étant compatible avec les applications usuelles de tels filtres de mode commun.

Un domaine auquel s'applique plus particulièrement la présente invention est l'utilisation de filtres de mode commun dans des systèmes de transmission radiofréquence. En particulier, des filtres de mode commun sont largement utilisés dans des équipements mobiles de communication de type téléphone portable et ce pour plusieurs raisons.

Une première raison est que les lignes différentielles véhiculant des données sont à haut débit et sont donc susceptibles de rayonner des signaux dans les différentes bandes de réception du dispositif de communication. Un filtre de mode commun sert alors à filtrer des bandes de réception du téléphone en étant placé généralement en sortie de l'émetteur différentiel.

Une autre raison est que l'antenne du téléphone est généralement d'une puissance (par exemple de l'ordre de 2 watts pour des téléphones GSM) suffisante pour que son rayonnement soit capté par les lignes véhiculant les signaux à haut débit dans les circuits électroniques. Pour éviter cela, un filtre de mode commun est placé à l'entrée du récepteur différentiel et filtre les bandes de fréquence d'émission du téléphone.

Un autre intérêt d'un filtre de mode commun est d'éviter des rayonnements en cas de déphasage (intrinsèque ou accidentel) des signaux différentiels. De tels déphasages peuvent provenir de légères différences de tracé des lignes conductrices sur des circuits intégrés ou imprimés. Sans filtre, la sensibilité et la réception du téléphone sont dégradées.

Le recours à des matériaux magnétiques est particulièrement gênant dans ces équipements que l'on cherche à miniaturiser à moindre coût.

Pour intégrer ou réduire le coût d'un filtre de mode commun, on pourrait penser supprimer le matériau magnétique de l'exemple de la figure 2, et réaliser les inductances sous la forme d'enroulements plans dans deux niveaux conducteurs superposés (séparés par un isolant). Toutefois, le couplage théorique maximal est alors de l'unité. Les valeurs d'inductance qu'il faudrait prévoir engendreraient un encombrement incompatible avec les souhaits de miniaturisation des circuits et dispositifs électroniques. Par exemple, pour obtenir une atténuation de mode commun d'environ 20 dB à 900 MHz (bande GSM), il faudrait des inductances d'environ 90 nH. Pour obtenir une faible résistance série, cela occuperait une surface irréaliste de plusieurs millimètres voire centimètres carrés.

Par ailleurs, la résistance série d'inductances de telles valeurs nuit à la transmission du mode différentiel. En outre, la structure engendrerait également des capacités parasites importantes. Ces modifications d'impédance du mode différentiel sont critiques pour des liaisons véhiculant des signaux numériques qui sont généralement adaptées en impédance.

La figure 3 représente un mode de réalisation d'un filtre 2 de mode commun.

Selon ce mode de réalisation, les bornes 22 et 24 d'entrée sont directement reliées aux bornes de sortie respectives 26 et 28. Par directement, on entend sans interposition d'éléments capacitifs, inductifs ou résistifs autre que les éléments parasites liés au tracé d'une ligne conductrice ou d'un fil entre ces bornes.

Pour simplifier la description qui va suivre, on fait référence à des bornes ou lignes 21 et 23 reliant respectivement les bornes 22 et 26 entre elles et les bornes 24 et 28 entre elles. En pratique, on peut également considérer que les bornes 22 et 26 sont communes de même que les bornes 24 et 28.

Les lignes ou bornes 21 et 23 destinées à véhiculer le signal différentiel sont, selon ce mode de réalisation, reliées par deux éléments capacitifs C25 et C26 de même valeur, en série, et le point milieu 27 de cette association en série est relié à la masse par un élément inductif L29.

Le fonctionnement est le suivant, lorsque des signaux en opposition de phase sont présentés sur les bornes 22 et 24, la différence de potentiel entre les bornes 21 et 23 est nulle. Par conséquent, le potentiel au point milieu 27 est également nul et aucun courant ne circule dans l'inductance L29. Par contre, en présence de signaux (plus exactement d'une composante) en phase (typiquement, une perturbation intervenant sur les deux signaux différentiels) sur les bornes 22 et 24, la différence de potentiel entre les bornes 21 et 23 n'est plus nulle. L'inductance L29 évacue alors le signal présent au noeud 27 vers la masse.

Ainsi, fonctionnellement, le filtre 2 évacue les perturbations de mode commun vers la masse au lieu de présenter une impédance série élevée entre les bornes d'entrée/sortie.

Le mode de réalisation de la figure 3 minimise donc l'impédance série pour les signaux de mode différentiel.

La figure 4 illustre un exemple de réponse en fréquence du filtre de la figure 3.

Ce filtre se comporte, pour les signaux de mode commun (allure mc en trait plein), comme un filtre coupe-bande centré sur une fréquence de résonance ou de coupure fc valant :

$$\frac{1}{2\pi \sqrt{L29 * (C25 + C26)}}.$$

On rappelle que les valeurs respectives des éléments capacitifs C25 et C26 sont égales pour respecter la symétrie des deux lignes. Par ailleurs, on considère que les éléments capacitifs et inductifs présentent une résistance série négligeable. Cette résistance série n'est de plus pas gênante car elle n'atténue pas le signal entre les bornes d'entrée et de sortie.

Les signaux de mode différentiel (allure md en pointillés) ne sont atténués que pour des fréquences beaucoup plus élevées. L'atténuation est essentiellement due aux capacités C25 et C26 qui sont de valeur relativement faible pour obtenir une large bande passante en mode différentiel.

Dans l'exemple de la figure 4, on a indiqué arbitrairement une atténuation A de 20 dB à la fréquence de coupure.

A titre d'exemple particulier de réalisation, un filtre tel qu'illustré en figure 3 réalisé avec des éléments capacitifs C25 et C26 d'environ 3 picofarads et un élément inductif L29 d'environ 4,65 nanohenrys présente une fréquence de coupure aux alentours de 950 MHz avec une atténuation de plus de 20 dB et procure une atténuation supérieure à 10 dB entre 880 MHz et 1,3 MHz. Côté bande passante différentielle, celle-ci est de 2 GHz (atténuation inférieure à 3 dB).

Le fait de ne filtrer qu'une bande étroite en mode commun n'est pas gênant dans la mesure où les perturbations de mode commun susceptibles d'interférer avec les signaux de mode différentiel sont dans la bande de fréquence du fonctionnement du téléphone portable, supposé dans l'exemple particulier de réalisation la bande GSM.

Plus généralement, on tire profit du fait que, dans de nombreuses applications, le mode commun que l'on souhaite filtrer correspond à une bande de fréquence identifiée, la bande passante de fonctionnement du dispositif, par exemple, les téléphones mobiles multi-bandes (GSM, DCS, PCS, WCDMA).

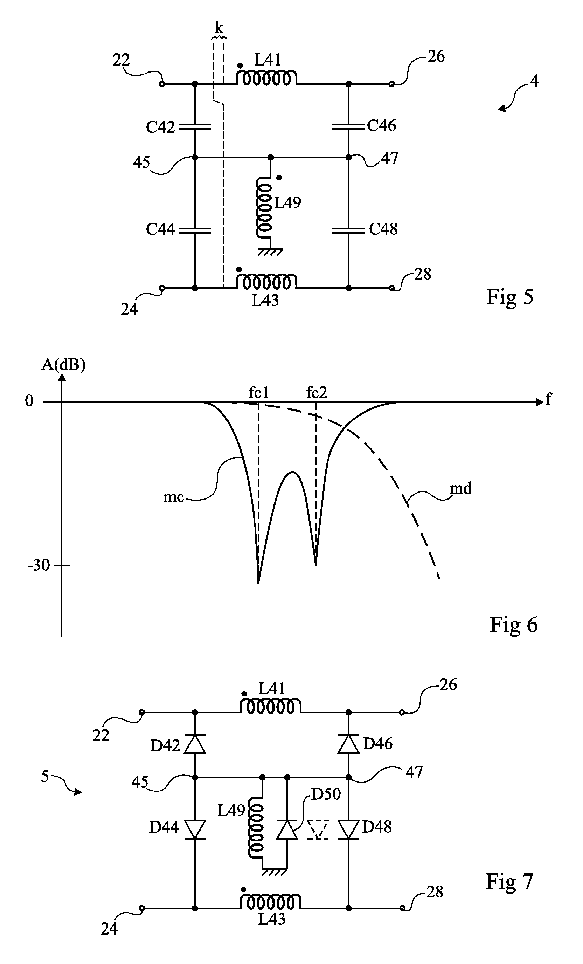

La figure 5 représente un autre mode de réalisation d'un filtre de mode commun.

Les bornes d'entrée 22 et 24 sont reliées par deux éléments capacitifs C42 et C44 en série. Les bornes de sortie 26 et 28 sont reliées par deux éléments capacitifs C46 et C48 en série. Les points milieu respectifs 45 et 47 de ces associations en série sont interconnectés et reliés à la masse par un premier élément inductif L49. Les bornes 22 et 26 sont reliées par un élément inductif L41 tandis que les bornes 24 et 28 sont reliées par un élément inductif L43.

Le mode de réalisation de la figure 5 permet, pour une fréquence de coupure donnée, de réduire les valeurs des éléments capacitifs. De préférence, les quatre éléments capacitifs sont de même valeur. En variante, les éléments C42 et C44 sont de même valeur et les éléments C46 et C48 sont de même valeur.

Par ailleurs, la présence des éléments inductifs L41 et L43 permet d'élargir la bande de coupure du filtre en mode commun. Les points de phase des éléments L41 et L43 sont du même côté afin de ne pas filtrer le mode différentiel. Les éléments L41 et L43 sont de même valeur pour préserver la symétrie du filtre.

La figure 6 illustre un exemple de réponse en fréquence du filtre de la figure 5. En mode commun (allure mc en trait plein), le filtre comporte une première fréquence de coupure fc1 conditionné par les éléments C42, C44 et L49. Cette fréquence fc1 vaut, en première approximation :

$$\frac{1}{2\pi \sqrt{2 * L49 * (C42 + C44)}}.$$

Une deuxième fréquence de coupure fc2 est conditionnée par les éléments L41, L43, C42, C44, C46, C48 et L49. En première approximation, on peut considérer qu'elle ne dépend que des éléments L41, C42 et C46 (ou L43, C44 et C48) et vaut :

$$\frac{1}{2\pi\sqrt{(L41*\dfrac{C42*C46}{C42+C46})}}.$$

A titre d'exemple particulier de réalisation, un filtre du type de celui de la figure 5 a été réalisé avec des éléments capacitifs C42, C44, C46 et C48 d'environ 1,8 picofarads et avec des éléments inductifs L41, L43 d'environ 8 nanohenrys et L49 d'environ 5,5 nanohenrys. Ce filtre présente, en mode commun, une atténuation supérieure à 10 dB entre environ 800 MHz et 2 GHz, ce qui permet de couvrir toutes les bandes actuelles de la téléphonie mobile (GSM, DCS, WCDMA, GPS, etc.). La bande passante en mode différentiel est de l'ordre de 1,85 GHz. La bande passante en mode différentiel est réduite par rapport au mode de réalisation de la figure 3 en raison de l'augmentation des capacités.

Pour réduire encore la taille des éléments capacitifs et inductifs, on peut coupler (sans matériau magnétique) les inductances L41 et L43. Une telle variante est illustrée par un pointillé en figure 5, symbolisant un couplage k.

Dans un montage intégré, un tel couplage peut être obtenu en réalisant les éléments L41 et L43 sous la forme d'enroulements plans conducteurs entrelacés ou superposés.

A titre d'exemple particulier de réalisation, un filtre selon cette variante a été réalisé avec des éléments capacitifs d'environ 750 femtofarads, des éléments inductifs L41 et L43 d'environ 13 nanohenrys couplés avec un coefficient de couplage de l'ordre de 0,85 (forcement inférieur à 1 en l'absence de matériau magnétique) et avec une inductance L49 d'environ 15 nanohenrys. La réponse en fréquence d'un tel filtre montre une atténuation supérieure à 20 dB entre 850 et 1,6 GHz et supérieure à 10 dB jusqu'à environ 2,25 GHz avec une bande passante différentielle allant jusqu'à environ 6 GHz.

La figure 7 représente encore un autre mode de réalisation d'un filtre de mode commun basé sur la structure du filtre de la figure 5 et associé à des éléments de protection contre des décharges électrostatiques (ESD). L'obtention de la protection ESD vient du remplacement des éléments capacitifs C42, C46, C48 et C44 par des diodes D42, D44, D46 et D48 dont les anodes respectives sont côtés points milieux 45 et 47. En outre, une diode additionnelle D50 est montée en parallèle sur l'élément inductif L49. Comme l'illustre le pointillé en figure 7, l'orientation de la diode D50 n'a pas d'importance. Le rôle de cette diode est de court-circuiter la surtension éventuellement générée par l'élément inductif L49 en cas de décharge électrostatique.

Le remplacement des éléments capacitifs par des diodes ne change la réponse du filtre que de façon négligeable.

Les structures décrites permettent de réaliser un filtre de mode commun sans recourir à des matériaux magnétiques tout en restant dans des valeurs d'inductance raisonnables d'un point de vue d'intégration.

Différents modes de réalisation avec diverses variantes ont été décrits. Diverses variantes et modifications apparaîtront à l'homme de l'art. On notera que l'homme de l'art pourra combiner divers éléments de ces divers modes de réalisation et variantes sans faire preuve d'activité inventive. En particulier, les valeurs à donner aux différents composants dépendent de l'application et des bandes de coupure souhaitées pour le mode commun. De plus, la réalisation pratique de l'invention sous forme de circuit intégré sur des substrats de verre ou autre isolant est à la portée de l'homme du métier à partir des indications fonctionnelles données ci-dessus et des contraintes que lui impose la technologie utilisée. En outre, bien que les modes de réalisation décrits s'appliquent particulièrement à une réalisation intégrée, ils peuvent également être réalisés sur circuit imprimé.

En outre, bien que l'on ait décrit des modes de réalisation dans lesquels le même élément inductif relie chaque élément capacitif aux bornes d'entrée et de sortie, on pourra prévoir des éléments inductifs distincts de mêmes valeurs au prix d'un encombrement plus important.

**Revendications**

1. Filtre (2 ; 4 ; 5) de mode commun comportant deux bornes (22, 24) d'entrée et deux bornes (26, 28) de sortie, et en série entre chaque borne d'entrée ou de sortie et la masse, un élément capacitif (C25, C26 ; C42, C44, C46, C48 ; D42, D44, D46, D48) et un premier élément inductif (L29 ; L49 ; L49), le premier élément inductif étant commun à tous les éléments capacitifs.

2. Filtre (2) selon la revendication 1, dans lequel une première borne d'entrée (22) est directement reliée ou est commune à une première borne de sortie (26), et une seconde borne d'entrée (24) est directement reliée ou est commune à une seconde borne de sortie (28).

3. Filtre (4 ; 5) selon la revendication 1, dans lequel une première borne d'entrée (22) est reliée à une première borne de sortie (26) par un deuxième élément inductif (L41), et une seconde borne d'entrée (24) est reliée à une seconde borne de sortie (28) par un troisième élément inductif (L43).

4. Filtre selon la revendication 3, dans lequel les deuxième et troisième éléments inductifs (L41, L43) sont couplés.

5. Filtre selon la revendication 3ou 4, dans lequel :

les bornes d'entrée (22, 24) sont connectées par deux éléments capacitifs (C42, C44) en série ; les bornes de sortie (26, 28) sont connectées par deux autres éléments capacitifs (C46, C48) en série, les points milieu (45, 47) des associations en série respectives des éléments capacitifs étant interconnectés à une première borne du premier élément inductif (L49) dont l'autre borne est à la masse.

6. Filtre selon l'une quelconque des revendications 1 à 5, dans lequel les éléments capacitifs sont formés par des diodes (D42, D44, D46, D48) dont les anodes respectives sont côté premier élément inductif (L49), une diode additionnelle (D50) étant connectée en parallèle sur cet élément inductif.

Fig 1

Fig 2

Fig 3

Fig 4

Fig 5

Fig 6

Fig 7

**Europäisches Patentamt**
**European Patent Office**
**Office européen des brevets**

## RAPPORT DE RECHERCHE EUROPEENNE

Numéro de la demande

EP 10 16 0432

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 2007/188265 A1 (PERREAULT DAVID J [US] ET AL) 16 août 2007 (2007-08-16) * abrégé; figures 5,15a,16a * * page 3, alinéa 50 * ----- | 1-4 | INV. H01P1/20 |
| A | JP 2 270414 A (TOSHIBA CORP) 5 novembre 1990 (1990-11-05) * abrégé; figure 4 * ----- | 6 | |
| A | US 5 142 430 A (ANTHONY ANTHONY A [US]) 25 août 1992 (1992-08-25) * abrégé; figure 2 * ----- | 5 | |

| DOMAINES TECHNIQUES RECHERCHES (IPC) |
|---|
| H01P |

Le présent rapport a été établi pour toutes les revendications

| Lieu de la recherche | Date d'achèvement de la recherche | Examinateur |
|---|---|---|
| Munich | 16 août 2010 | Cordeiro, J |

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 10 16 0432

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

16-08-2010

| Document brevet cité au rapport de recherche | Date de publication | Membre(s) de la famille de brevet(s) | Date de publication |
|---|---|---|---|
| US 2007188265 A1 | 16-08-2007 | WO 2007094921 A1 | 23-08-2007 |
| JP 2270414 A | 05-11-1990 | AUCUN | |
| US 5142430 A | 25-08-1992 | AT 139066 T | 15-06-1996 |
| | | DE 69120063 D1 | 11-07-1996 |
| | | DE 69120063 T2 | 16-01-1997 |
| | | DK 0523190 T3 | 21-10-1996 |
| | | EP 0523190 A1 | 20-01-1993 |
| | | ES 2091329 T3 | 01-11-1996 |
| | | JP 2531557 B2 | 04-09-1996 |
| | | JP 5504880 T | 22-07-1993 |
| | | WO 9115046 A1 | 03-10-1991 |

EPO FORM P0460

Pour tout renseignement concernant cette annexe : voir Journal Officiel de l'Office européen des brevets, No.12/82